# EUROPEAN PATENT APPLICATION

(11) **EP 3 967 492 A1**
(43) Date of publication of application: **16.03.2022**
(21) Application number: 21191957.6
(22) Date of filing: 18.08.2021
(51) Int. Cl.: B32B 27/08, B32B 27/18, B32B 27/26, B32B 27/28, B32B 27/30, B32B 27/32, C09J 7/10, H01L 31/048, C08G 77/04, C08G 77/14

(54) **HOT MELT ADHESIVE FILM, AND PREPARATION METHOD, USE, AND ORGANOSILICON POLYMER THEREOF**

(30) Priority: 19.08.2020 CN 202010837354
(71) Applicant: Changzhou Betterial Film Technologies Co., Ltd., Lijia Town, Wujin District Changzhou City, Jiangsu (CN)
(72) Inventor: RU, Zhengwei, Changzhou City (CN); XIONG, Weicheng, Changzhou City (CN); ZHOU, Le, Changzhou City (CN)
(74) Representative: Patentanwälte Gierlich & Pischitzis Partnerschaft mbB

(57) **Abstract**

A hot melt adhesive film, and a preparation method, use, and an organosilicon polymer thereof are provided. The hot melt adhesive film includes: an inner layer, which is a polyolefin elastomer (POE); outer layers, which are an ethylene-vinyl acetate (EVA) copolymer on two surfaces of the inner layer; and intermediate layers, which are an organosilicon polymer between the inner layer and the outer layers. As intermediate layers, the organosilicon polymer plays the role of connection and transition, improves a bonding force between EVA and POE layers, and improves the stability of the hot melt adhesive film during long-term use. The hot melt adhesive film can be used as a packaging material for solar panels, touch screens, and the like.

## Description

### TECHNICAL FIELD

The present disclosure belongs to the technical field of adhesive films, and specifically relates to a hot melt adhesive film, and a preparation method, use, and an organosilicon polymer thereof.

### BACKGROUND

The existing hot melt adhesive film with an ethylene-vinyl acetate (EVA)/polyolefin elastomer (POE)/EVA structure has excellent water vapor-proof characteristics and anti-Potential Induced Degradation (PID) characteristics, and is gradually replacing the EVA copolymer film to become the main packaging material. However, the POE is a non-polar resin, the EVA copolymer is a polar resin, and the two resins are significantly different in the crosslinking reactivity, melt viscosity, and melt shear heating rate, resulting in delamination of the adhesive film made by co-extrusion of the two materials. The long-term aging process of the co-extruded adhesive film will increase the risk of delamination of the two materials. Thus, the decrease in bonding force between the EVA and POE layers leads to the delamination between the layers inside the packaging material, thereby shortening the service lives of solar panels and touch panels.

### SUMMARY

The present disclosure provides a hot melt adhesive film, and a preparation method, use, and an organosilicon polymer thereof.

In order to solve the above technical problems, the present disclosure provides a hot melt adhesive film, including: an inner layer, which is a POE; outer layers, which are an EVA copolymer on two surfaces of the inner layer; and intermediate layers, which are an organosilicon polymer between the inner layer and the outer layers.

In a second aspect, the present disclosure also provides a manufacturing process of the hot melt adhesive film, including: using the POE as an inner layer and the EVA copolymer as outer layers on two surfaces of the inner layer to form a three-layer co-extruded film by co-extrusion; and subjecting the three-layer co-extruded film to ultraviolet (UV) irradiation, such that the siloxane with a special polar structure in the POE undergoes an addition reaction to form an organosilicon polymer, which is the intermediate layer.

In a third aspect, the present disclosure also provides an organosilicon polymer with the following chemical structural formula:

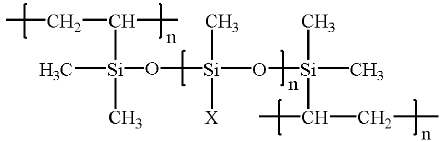

In a fourth aspect, the present disclosure also provides the use of the hot melt adhesive film as an adhesive.

Beneficial effects of the present disclosure: In the hot melt adhesive film of the present disclosure, an organosilicon polymer is used as intermediate layers between the POE inner layer and the EVA copolymer outer layers, which plays the role of connection and transition, improves a bonding force between EVA and POE layers, and improves the stability of the hot melt adhesive film during long-term use. The hot melt adhesive film can be used as a packaging material for solar panels, touch screens, and so on.

Other features and advantages of the present disclosure will be described in the following description, and some of these will become apparent from the description or be understood by implementing the present disclosure. The objectives and other advantages of the present disclosure can be implemented or obtained by structures specifically indicated in the description and accompanying drawings.

In order to make the above obj ectives, features, and advantages of the present disclosure more understandable, the present disclosure is described in detail below using preferred examples with reference to the accompanying drawings.

### BRIEF DESCRIPTION OF THE DRAWINGS

To describe the technical solutions in the specific implementations of the present disclosure or the prior art more clearly, the accompanying drawings required for describing the specific implementations or the prior art are briefly described below. Apparently, the accompanying drawings in the following description show merely some implementations of the present disclosure, and a person of ordinary skill in the art may still derive other accompanying drawings from these accompanying drawings without creative efforts.
FIG. 1 is a flow chart of the manufacturing process of the hot melt adhesive film according to the present disclosure;
FIG. 2 shows a migration process of the siloxane with a special polar structure;
FIG. 3 is a scanning electron microscopy (SEM) image of the hot melt adhesive film according to the present disclosure.
FIG. 4 is an infrared schematic diagram of the connection and transition layer according to the present disclosure;
FIG. 5 is a schematic structural diagram of the existing hot melt adhesive film with an EVA/POE/EVA three-layer structure;
FIG. 6 is a gel permeation chromatography (GPC) spectrum of the connection and transition layer before UV irradiation according to the present disclosure; and
FIG. 7 is a GPC spectrum of the connection and transition layer after UV irradiation according to the present disclosure.

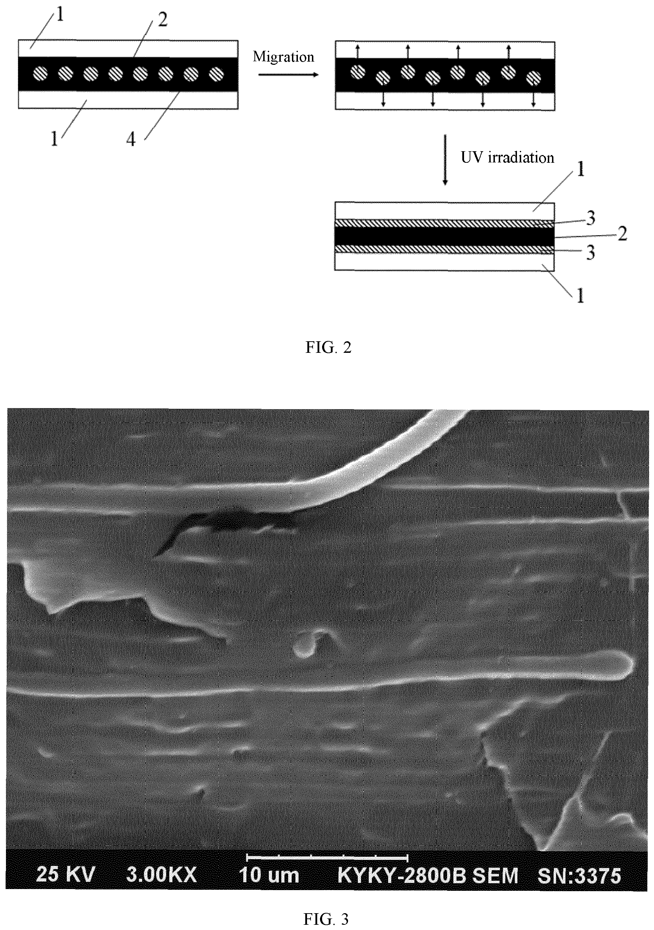

In FIG. 2: 1 represents the POE, 2 represents the EVA copolymer, 3 represents the organosilicon polymer, and 4 represents the siloxane with a special polar structure.

### DETAILED DESCRIPTION OF THE EMBODIMENTS

In order to make the objectives, technical solutions, and advantages of the examples of the present disclosure clearer, the technical solutions in the present disclosure are described clearly and completely below with reference to the accompanying drawings. Apparently, the described examples are some rather than all of the examples. All other examples obtained by a person of ordinary skill in the art based on the examples of the present disclosure without creative efforts shall fall within the protection scope of the present disclosure.

### Part 1: Explanation of specific technical solutions

In the existing adhesive film with an EVA/POE/EVA structure, POE is a non-polar resin, EVA copolymer is a polar resin, and the two resins are significantly different in the crosslinking reactivity, melt viscosity, and melt shear heating rate, so the adhesive film resulting from co-extrusion of the two will undergo delamination. In view of this, as shown in FIG. 2, the present disclosure provides a hot melt adhesive film, including: an inner layer, which is a POE 1; outer layers, which are an EVA copolymer 2 on two surfaces of the inner layer; and intermediate layers, which are an organosilicon polymer 3 between the inner layer and the outer layers, also called connection and transition layers.

The hot melt adhesive film of the present disclosure adopts the combination of an inner layer, two intermediate layers, and two outer layers to form a five-layer composite structure, where the POE and the organosilicon polymer are covered by the EVA copolymer outer layers, such that there will be no roller sticking or the like. Through hot-pressing and UV irradiation, the five-layer composite structure of the hot melt adhesive film can meet the use requirements for a crosslinking degree. Compared with the existing hot melt adhesive film with an EVA/POE/EVA three-layer structure, the hot melt adhesive film of the present disclosure has excellent light transmittance, water vapor barrier performance, insulation, pass yield, etc. As a connection and transition layer, the organosilicon polymer improves a bonding force between EVA and POE layers and enhances the stability during long-term use. The hot melt adhesive film of the present disclosure can be used as a packaging material for solar panels, touch screens, and so on.

### As an alternative implementation of the POE:

The POE may include the following components, in parts by mass: POE masterbatch: 92.25 to 97.8 parts; siloxane with a special polar structure: 1 to 2.5 parts; antioxidant: 0.1 to 1 part; thermal initiator: 0.5 to 2 parts; crosslinking monomer: 0.5 to 2.5 parts; and light stabilizer: 0.1 to 1 part.

Optionally, the POE may include the following components, in parts by mass: POE masterbatch: 93 to 97.3 parts; siloxane with a special polar structure: 1.5 to 2 parts; antioxidant: 0.5 to 0.8 part; thermal initiator: 0.8 to 1.5 parts; crosslinking monomer: 1 to 2 parts; and light stabilizer: 0.4 to 0.8 part.

Optionally, the siloxane with a special polar structure may have the following chemical structural formula: 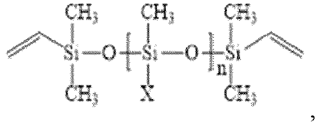 where X is -R or -OR and R is C2-C6.

Specifically, the organosilicon polymer may preferably be produced by subjecting the siloxane to an addition reaction, and the addition reaction may have the following reaction equation: 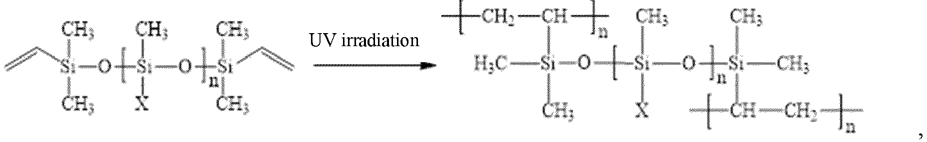 where X is -R or -OR and R is C2-C6.

### As an alternative implementation of the EVA copolymer:

The EVA copolymer may include the following components, in parts by mass: EVA copolymer masterbatch: 91.5 to 99.1 parts; antioxidant: 0.1 to 1 part; thermal initiator: 0.3 part to 1.5 parts; crosslinking monomer: 0.3 to 2 parts; silane coupling agent (SCA): 0.1 to 1 part; and light stabilizer: 0.1 to 1 part.

Optionally, the EVA copolymer may include the following components, in parts by mass: EVA copolymer masterbatch: 93.8 to 98.9 parts; antioxidant: 0.2 to 0.8 part; thermal initiator: 0.5 part to 1.2 parts; crosslinking monomer: 0.4 to 1.9 parts; SCA: 0.2 to 0.8 part; and light stabilizer: 0.4 to 10.8 parts.

Optionally, some pigments can be added to the EVA copolymer to make an outer layer of a corresponding color without affecting the UV light transmission.

Among the components of the POE and EVA copolymer in the present disclosure, the antioxidant, thermal initiator, crosslinking monomer, SCA, and light stabilizer can be, but not limited to, the following materials:

Optionally, the antioxidant may be one or a combination of two or more from the group consisting of pentaerythritol tetrakis (3-(3,5-di-*tert*-butyl-4-hydroxyphenyl)propionate), triethylene glycol bis(3-*tert*-butyl-4-hydroxy-5-methylphenyl)propionate, and tris(4-*tert*-butyl-3-hydroxy-2,6-dimethylbenzyl)isocyanurate.

Optionally, the thermal initiator may be one or a combination of two or more from the group consisting of dicumyl peroxide (DCP), di-*tert*-butyl peroxide (DTBP), diisopropylbenzene hydroperoxide, 2,5-dimethyl-2,5-di- (*tert*-butylperoxy) hexane, *n*-butyl 4,4-bis(*tert*-amylperoxy) valerate, *tert*-butyl peroxy-2-ethylhexanoate, and ethyl 3,3-bis(tert-butylperoxy) butanoate.

Optionally, the crosslinking monomer may be one or a combination of two or more from the group consisting of triallyl isocyanurate (TAIC), triallyl cyanurate (TAC), trimethylolpropane trimethacrylate (TMPTMA), and ethylene glycol dimethacrylate (EGDMA).

Optionally, the SCA may be one or a combination of two or more from the group consisting of vinyltriethoxysilane (VTES), vinyltrimethoxysilane (VTMS), vinyl triperoxide *tert-butyl* silane, vinyltriacetoxysilane (VTAS), and vinyl-tris(β-methoxyethoxy) silane. As the POE inner layer and the organosilicon polymer intermediate layers in the hot melt adhesive film are covered by the EVA copolymer outer layers, there will be no roller sticking or the like. Since a cost of EVA copolymer is lower than a cost of POE, the hot melt adhesive film can be given high water resistance and PID resistance at a low cost.

Optionally, the light stabilizer may be one or a combination of two or more from the group consisting of bis-(1-octyloxy-2,2,6,6-tetramethyl-4-piperidinyl) sebacate, poly-{[6-[(1,1,3,3-tetramethylbutyl)-imino]-1,3,5-triazine-2,4-diyl][2-(2,2,6,6-tetramethylpiperidinyl)-nitrilo-hexamethylene-[4-(2,2,6,6-tetramethylpiperidinyl)-nitrilo]], bis(2,2,6,6-tetramethyl-4-piperidinyl) sebacate, and poly(4-hydroxy-2,2,6,6-tetramethyl-1-piperidineethanol-alt-1,4-butanedioic acid).

In the present disclosure, the raw material differentiation design of the EVA copolymer and POE is used to ensure that the different components of the two are limited to POE masterbatch, EVA copolymer masterbatch, and siloxane with a special polar structure, a mass percentage of the thermal initiator in the POE is higher than a mass percentage of the thermal initiator in the EVA copolymer, and a mass percentage of the crosslinking monomer in the POE is higher than a mass percentage of the crosslinking monomer in the EVA copolymer, such that the surface energy of the outer layer melt (EVA copolymer) is greater than the surface energy of the inner layer melt (POE) during co-extrusion.

Optionally, a mass ratio of the POE to the EVA copolymer may be (10-50):(50-90) and optionally (15-45):(50-95). Amass percentage of the thermal initiator in the POE may be 0.2% to 0.5% higher than a mass percentage of the thermal initiator in the EVA copolymer; and a mass percentage of the crosslinking monomer in the POE may be 0.2% to 0.5% higher than a mass percentage of the crosslinking monomer in the EVA copolymer.

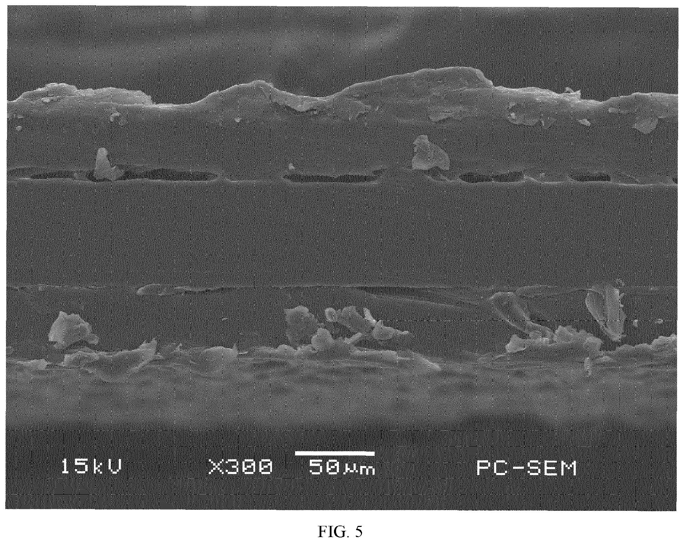

As shown in FIG. 2, during co-extrusion, the surface energy of the outer layer melt (EVA copolymer 1) is greater than the surface energy of the inner layer melt (POE 2), such that the siloxane 4 with a special polar structure migrates from a position with the low surface energy to a position with the high surface energy to settle at an interface between EVA copolymer and POE; and through UV irradiation, the siloxane undergoes an addition reaction to generate the organosilicon polymer 3, thereby forming an intermediate layer, which plays the role of connection and transition. Compared with the existing hot melt adhesive film which has an EVA/POE/EVAthree-layer structure with faults (as shown in FIG. 5), in the hot melt adhesive film of the present disclosure, a bonding force at the interface is greatly improved and delamination can be effectively avoided.

In the present disclosure, the migration behavior of the siloxane with a special polar structure is determined by a surface energy difference between the EVA copolymer and the POE; and as the siloxane migration proceeds, the surface energy difference between the EVA copolymer and the POE gradually decreases inevitably until each melt is maintained in a stable state. Therefore, the surface energy difference between the EVA copolymer and the POE can be controlled through a raw material formulation (for example, the outer layer melt has a surface tension of 35 mN/m to 37 mN/m and the inner layer melt has a surface tension of 31 mN/m to 33 mN/m), such that most of the siloxane with a special polar structure will migrate to an interface, and a small part will be unable to migrate and thus stay in the POE. Therefore, after UV irradiation, the organosilicon polymer generated from the addition reaction of the siloxane will connect the EVA copolymer with the POE to further strengthen a bonding force at the interface.

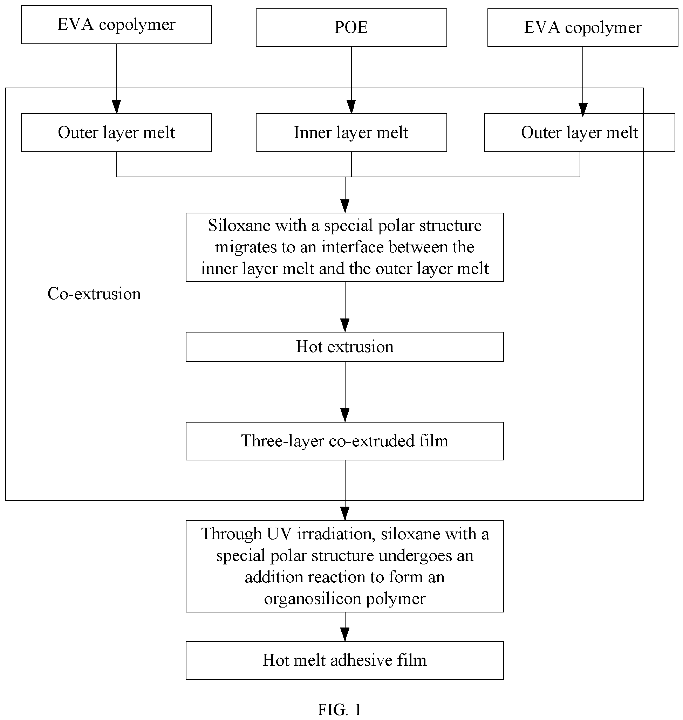

Further, as shown in FIG. 1, the present disclosure also provides a manufacturing process of the hot melt adhesive film, including: using the POE as an inner layer and the EVA copolymer as outer layers on two surfaces of the inner layer to form a three-layer co-extruded film by co-extrusion; and subjecting the three-layer co-extruded film to UV irradiation, such that the siloxane with a special polar structure in the POE undergoes an addition reaction to form an organosilicon polymer, which is the intermediate layer. Specifically, the hot melt adhesive film has a five-layer structure including: a POE inner layer, two EVA copolymer outer layers, and two organosilicon polymer intermediate layers between the inner layer and the outer layers.

### As an alternative implementation of the co-extrusion:

The co-extrusion may include: mixing and melting the components of the POE to form an inner layer melt; mixing and melting the components of the EVA copolymer to form an outer layer melt; placing the outer layer melt on upper and lower surfaces of the inner layer melt, such that the siloxane with a special polar structure in the inner layer melt migrates to an interface between the inner layer melt and the outer layer melt; and conducting hot extrusion through a die to obtain the three-layer co-extruded film.

Optionally, the surface energy of the outer layer melt may be greater than the surface energy of the inner layer melt, such that the siloxane with a special polar structure migrates from a position with the low surface energy to a position with a high surface energy; the outer layer melt may have a surface tension of 35 mN/m to 37 mN/m; and the inner layer melt may have a surface tension of 31 mN/m to 33 mN/m.

Further, the present disclosure provides an organosilicon polymer with the following chemical structural formula:

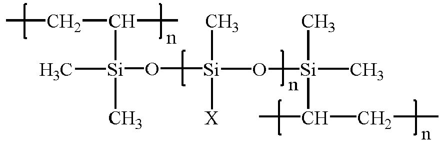

Further, the present disclosure provides the use of the hot melt adhesive film as an adhesive.

For example, the adhesive can be used as a packaging material for solar panels, touch screens, and so on.

### Part 2: Recitation of some examples

### Example 1

(1) POE for an inner layer was prepared from the following components: POE masterbatch: 95 kg, siloxane with a special polar structure: 1.2 kg, antioxidant: 0.5 kg, thermal initiator: 1.6 kg, crosslinking monomer: 1.5 kg, and light stabilizer: 0.2 kg; and EVA copolymer for an outer layer was prepared from the following components: EVA copolymer masterbatch: 96.2 kg, antioxidant: 0.6 kg, thermal initiator: 0.8 kg, crosslinking monomer: 1.6 kg, SCA: 0.4 kg, and light stabilizer: 0.2 kg.
(2) One copy of the POE raw material formulation and two copies of the EVA copolymer raw material formulation were added to a corresponding feeding cylinder separately, and extruded at 100°C to obtain one inner layer melt and two outer layer melts; with a distributor and a co-extrusion die, the inner layer melt and the outer layer melts were subjected to co-extrusion to obtain a three-layer co-extruded film; and then the three-layer co-extruded film was subjected to UV irradiation to obtain a hot melt adhesive film with a five-layer composite structure.

### Example 2

(1) POE for an inner layer was prepared from the following components: POE masterbatch: 94.8 kg, siloxane with a special polar structure: 1.6 kg, antioxidant: 0.5 kg, thermal initiator: 1.5 kg, crosslinking monomer: 1.4 kg, and light stabilizer: 0.2 kg; and EVA copolymer for an outer layer was prepared from the following components: EVA copolymer masterbatch: 97.1 kg, antioxidant: 0.5 kg, thermal initiator: 0.6 kg, crosslinking monomer: 1.2 kg, SCA: 0.4 kg, and light stabilizer: 0.2 kg.
(2) One copy of the POE raw material formulation and two copies of the EVA copolymer raw material formulation were added to a corresponding feeding cylinder separately, and extruded at 100°C to obtain one inner layer melt and two outer layer melts; with a distributor and a co-extrusion die, the inner layer melt and the outer layer melts were subjected to co-extrusion to obtain a three-layer co-extruded film; and then the three-layer co-extruded film was subjected to UV irradiation to obtain a hot melt adhesive film with a five-layer composite structure.

### Example 3

(1) POE for an inner layer was prepared from the following components: POE masterbatch: 95.1 kg, siloxane with a special polar structure: 1.6 kg, antioxidant: 0.5 kg, thermal initiator: 1.4 kg, crosslinking monomer: 1.2 kg, and light stabilizer: 0.2 kg; and EVA copolymer for an outer layer was prepared from the following components: EVA copolymer masterbatch: 96.5 kg, antioxidant: 0.5 kg, thermal initiator: 0.9 kg, crosslinking monomer: 1.3 kg, SCA: 0.6 kg, and light stabilizer: 0.2 kg.
(2) One copy of the POE raw material formulation and two copies of the EVA copolymer raw material formulation were added to a corresponding feeding cylinder separately, and extruded at 100°C to obtain one inner layer melt and two outer layer melts; with a distributor and a co-extrusion die, the inner layer melt and the outer layer melts were subjected to co-extrusion to obtain a three-layer co-extruded film; and then the three-layer co-extruded film was subjected to UV irradiation to obtain a hot melt adhesive film with a five-layer composite structure.

### Example 4

(1) POE for an inner layer was prepared from the following components: POE masterbatch: 93.3 kg, siloxane with a special polar structure: 2.3 kg, antioxidant: 0.4 kg, thermal initiator: 1.6 kg, crosslinking monomer: 2.2 kg, and light stabilizer: 0.2 kg; and EVA copolymer for an outer layer was prepared from the following components: EVA copolymer masterbatch: 97.6 kg, antioxidant: 0.6 kg, thermal initiator: 0.8 kg, crosslinking monomer: 0.5 kg, SCA: 0.3 kg, and light stabilizer: 0.2 kg.
(2) One copy of the POE raw material formulation and two copies of the EVA copolymer raw material formulation were added to a corresponding feeding cylinder separately, and extruded at 100°C to obtain one inner layer melt and two outer layer melts; with a distributor and a co-extrusion die, the inner layer melt and the outer layer melts were subjected to co-extrusion to obtain a three-layer co-extruded film; and then the three-layer co-extruded film was subjected to UV irradiation to obtain a hot melt adhesive film with a five-layer composite structure.

### Example 5

(1) POE for an inner layer was prepared from the following components: POE masterbatch: 94.6 kg, siloxane with a special polar structure: 1.9 kg, antioxidant: 0.4 kg, thermal initiator: 1.2 kg, crosslinking monomer: 1.7 kg, and light stabilizer: 0.2 kg; and EVA copolymer for an outer layer was prepared from the following components: EVA copolymer masterbatch: 95.6 kg, antioxidant: 0.2 kg, thermal initiator: 1.4 kg, crosslinking monomer: 1.8 kg, SCA: 0.8 kg, and light stabilizer: 0.2 kg.
(2) One copy of the POE raw material formulation and two copies of the EVA copolymer raw material formulation were added to a corresponding feeding cylinder separately, and extruded at 100°C to obtain one inner layer melt and two outer layer melts; with a distributor and a co-extrusion die, the inner layer melt and the outer layer melts were subjected to co-extrusion to obtain a three-layer co-extruded film; and then the three-layer co-extruded film was subjected to UV irradiation to obtain a hot melt adhesive film with a five-layer composite structure.

### Example 6

(1) POE for an inner layer was prepared from the following components: POE masterbatch: 92.25kg, siloxane with a special polar structure: 1kg, antioxidant: 1kg, thermal initiator: 2kg, crosslinking monomer: 2.5kg, and light stabilizer: 1 kg; and EVA copolymer for an outer layer was prepared from the following components: EVA copolymer masterbatch: 91.5kg, antioxidant: 0.1kg, thermal initiator: 0.3kg, crosslinking monomer: 0.3kg, SCA: 0.1kg, and light stabilizer: 0.1 kg.
(2) One copy of the POE raw material formulation and two copies of the EVA copolymer raw material formulation were added to a corresponding feeding cylinder separately, and extruded at 100°C to obtain one inner layer melt and two outer layer melts; with a distributor and a co-extrusion die, the inner layer melt and the outer layer melts were subjected to co-extrusion to obtain a three-layer co-extruded film; and then the three-layer co-extruded film was subjected to UV irradiation to obtain a hot melt adhesive film with a five-layer composite structure.

### Example 7

(1) POE for an inner layer was prepared from the following components: POE masterbatch: 97.8 kg, siloxane with a special polar structure: 2.5 kg, antioxidant: 0.1 kg, thermal initiator: 0.5 kg, crosslinking monomer: 0.5 kg, and light stabilizer: 0.1 kg; and EVA copolymer for an outer layer was prepared from the following components: EVA copolymer masterbatch: 99.1 kg, antioxidant: 1 kg, thermal initiator: 1.5 kg, crosslinking monomer: 2 kg, SCA: 1 kg, and light stabilizer: 1 kg.
(2) One copy of the POE raw material formulation and two copies of the EVA copolymer raw material formulation were added to a corresponding feeding cylinder separately, and extruded at 100°C to obtain one inner layer melt and two outer layer melts; with a distributor and a co-extrusion die, the inner layer melt and the outer layer melts were subjected to co-extrusion to obtain a three-layer co-extruded film; and then the three-layer co-extruded film was subjected to UV irradiation to obtain a hot melt adhesive film with a five-layer composite structure.

### Comparative Example 1

(1) POE for an inner layer was prepared from the following components: POE masterbatch: 96.5 kg, antioxidant: 0.2 kg, thermal initiator: 1.2 kg, crosslinking monomer: 1.6 kg, SCA: 0.5 kg, and light stabilizer: 0.2 kg; and EVA copolymer for an outer layer was prepared from the following components: EVA copolymer masterbatch: 94.8 kg, antioxidant: 0.4 kg, thermal initiator: 1.4 kg, crosslinking monomer: 2.0 kg, SCA: 1.0 kg, and light stabilizer: 0.4 kg.
(2) One copy of the POE raw material formulation and two copies of the EVA copolymer raw material formulation were added to a corresponding feeding cylinder separately, and extruded at 100°C to obtain one inner layer melt and two outer layer melts; with a distributor and a co-extrusion die, the inner layer melt and the outer layer melts were subjected to co-extrusion to obtain a three-layer co-extruded film; and then the three-layer co-extruded film was subjected to UV irradiation to obtain a hot melt adhesive film.

### Part 3: Comparative analysis of performance parameters

In this part, the hot melt adhesive films with a five-layer composite structure prepared in Examples 1 to 5, the hot melt adhesive film prepared from raw materials excluding the siloxane with a special polar structure (Comparative Example 1), and the existing hot melt adhesive film (Comparative Example 2) were laminated with photovoltaic glass at 145°C for 15 min, and then the films were tested for performance. Results were shown in Table 1.

**Table 1 Performance comparison of hot melt adhesive films**

| | Lamination peeling force (N/cm) | Light transmittance (%) | Haze (%) | Crosslinking degree (%) |
|---|---|---|---|---|
| Example 1 | 148 | 91.5 | 0.6 | 90 |
| Example 2 | 136 | 91.1 | 0.7 | 88 |
| Example 3 | 127 | 91.4 | 0.7 | 75 |
| Example 4 | 118 | 91.3 | 0.5 | 83 |
| Example 5 | 103 | 92.2 | 0.5 | 81 |
| Comparative Example 1 | 74 | 92.5 | 0.3 | 73 |
| Comparative Example 2 | 66 | 92.6 | 0.3 | 85 |

It can be seen from Table 1 that the hot melt adhesive films with a five-layer composite structure in the present disclosure have a high lamination peeling force. This is mainly because the siloxane with a special polar structure migrates from the POE to an interface between the EVA copolymer and the POE and then undergoes an addition reaction under UV irradiation to generate the organosilicon polymer to form an intermediate layer, which plays the role of connection and transition. As shown in FIG. 3, there is no obvious fault between the inner layer and the outer layer in the hot melt adhesive film with a five-layer composite structure, which also confirms the high lamination peeling force of the hot melt adhesive film.

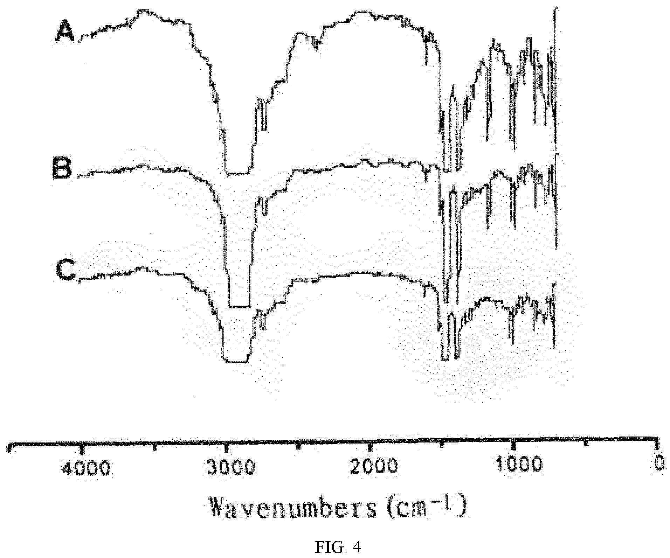

As shown in FIG. 4, the siloxane was added at varying amounts in the preparation of the hot melt adhesive film, with the other components unchanged, and obtained products were subjected to infrared spectrometry to verify the formation of the organosilicon polymer. In the infrared spectra, the characteristic peak of Si-C at 1250 cm⁻¹ are strong, weak, and absent, respectively; and A represents the addition of 18 parts of siloxane, B represents the addition of 1.2 parts of siloxane, and C represents the addition of no siloxane. It can be seen that, when 1.8 parts of siloxane are added in the hot melt adhesive film with a five-layer composite structure, the maximum amount of organosilicon polymer is formed, and the hot melt adhesive film has the highest lamination peeling force.

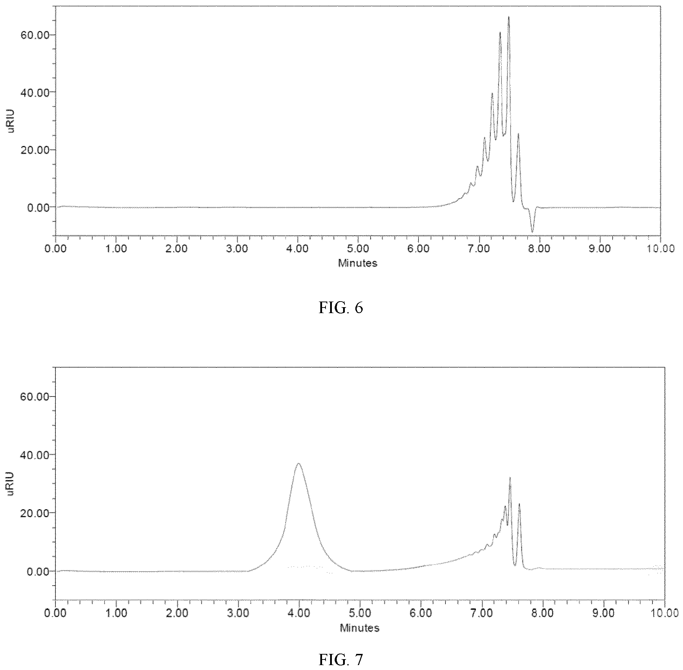

As shown in FIG. 6 and FIG. 7, a molecular weight of the connection and transition layer changed before and after UV irradiation, indicating that the siloxane with a special polar structure underwent addition polymerization to generate the organosilicon polymer.

In summary, in the manufacturing process of the hot melt adhesive film of the present disclosure, the siloxane with a special polar structure in the POE migrates to an interface between the EVA copolymer and the POE and then undergoes an addition reaction under UV irradiation to generate the organosilicon polymer (which is the intermediate layer), such that a hot melt adhesive film with a five-layer composite structure is formed. The intermediate layer plays the role of connection and transition, increases a bonding force between the EVA and POE layers, and improves the stability of the hot melt adhesive film during long-term use. The hot melt adhesive film can be used as a packaging material for solar panels, touch screens, and so on.

Under the inspiration of the above ideal examples of the present disclosure, a skilled person can absolutely make various changes and modifications through the above description content without departing from the scope of the technical idea of the present disclosure. The technical scope of the present disclosure is not limited to the content of the description, which must be determined according to the scope of the claims.

## Claims

1. A hot melt adhesive film, comprising:
an inner layer, wherein the inner layer is a polyolefin elastomer (POE);
outer layers, wherein the outer layers are an ethylene-vinyl acetate (EVA) copolymer on two surfaces of the inner layer; and
intermediate layers, wherein the intermediate layers are an organosilicon polymer between the inner layer and the outer layers;
wherein the POE comprises the following components, in parts by mass: 92.25 to 97.8 parts of POE masterbatch;
1 to 2.5 parts of siloxane with a special polar structure;
0.1 to 1 part of antioxidant;
0.5 to 2 parts of thermal initiator;
0.5 to 2.5 parts of crosslinking monomer; and
0.1 to 1 part of light stabilizer;
the siloxane has the following chemical structural formula: 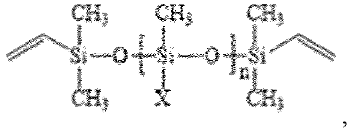 wherein X is -R or -OR and R is C2-C6;
the organosilicon polymer is produced by subjecting the siloxane to an addition reaction, and the addition reaction has the following reaction equation: 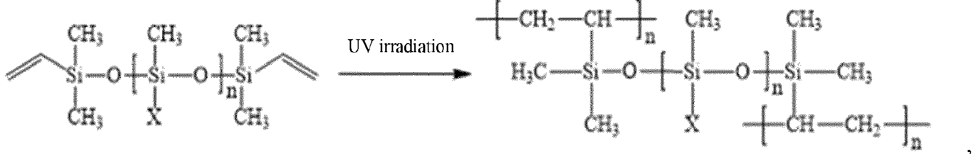 wherein X is -R or -OR and R is C2-C6.

2. The hot melt adhesive film according to claim 1, wherein the EVA copolymer comprises the following components, in parts by mass:
91.5 to 99.1 parts of EVA copolymer masterbatch;
0.1 to 1 part of antioxidant;
0.3 to 1.5 parts of thermal initiator;
0.3 to 2 parts of crosslinking monomer;
0.1 to 1 part of silane coupling agent (SCA); and
0.1 to 1 part of light stabilizer.

3. The hot melt adhesive film according to claim 2, wherein
a mass percentage of the thermal initiator in the POE is higher than a mass percentage of the thermal initiator in the EVA copolymer;
a mass percentage of the crosslinking monomer in the POE is higher than a mass percentage of the crosslinking monomer in the EVA copolymer; and
a mass ratio of the POE to the EVA copolymer is (10-50):(50-90).

4. A manufacturing process of the hot melt adhesive film according to claim 1, comprising:
using the POE as the inner layer and the EVA copolymer as the outer layers on two surfaces of the inner layer to form a three-layer co-extruded film by co-extrusion; and
subjecting the three-layer co-extruded film to ultraviolet (UV) irradiation, wherein the siloxane with the special polar structure in the POE undergoes an addition reaction to form the organosilicon polymer as the intermediate layers.

5. The manufacturing process according to claim 4, wherein
the co-extrusion comprises:
mixing and melting the components of the POE to form an inner layer melt;
mixing and melting the components of the EVA copolymer to form an outer layer melt;
placing the outer layer melt on upper and lower surfaces of the inner layer melt, wherein the siloxane with the special polar structure in the inner layer melt migrates to an interface between the inner layer melt and the outer layer melt; and
conducting hot extrusion through a die to obtain the three-layer co-extruded film.

6. The manufacturing process according to claim 5, wherein
a surface energy of the outer layer melt is greater than a surface energy of the inner layer melt, wherein the siloxane with a special polar structure migrates from a position with a low surface energy to a position with a high surface energy;
the outer layer melt has a surface tension of 35 mN/m to 37 mN/m; and
the inner layer melt has a surface tension of 31 mN/m to 33 mN/m.

7. An application method for the hot melt adhesive film according to claim 1, using the hot melt adhesive film as an adhesive.
